# EUROPEAN PATENT APPLICATION

(11) **EP 4 761 098 A1**
(43) Date of publication of application: **17.06.2026**
(21) Application number: 24219866.1
(22) Date of filing: 13.12.2024
(51) Int. Cl.: H02P 6/08, H02P 29/024, E05F 15/659, H02P 7/03, H02P 29/68

(54) **DRIVE CIRCUIT FOR AN ELECTRIC MOTOR FOR USE IN A ROOF ASSEMBLY**

(71) Applicant: Inalfa Roof Systems Group B.V., 5807 GW Oostrum (NL)
(72) Inventor: Van Leuveren, Tim Henk, 5807 GW Oostrum (NL); Van de Pol, Jochem Amadeus, 5807 GW Oostrum (NL)
(74) Representative: De Vries & Metman

(57) **Abstract**

The invention relates to a drive circuit (12) for a roof assembly, the roof assembly comprising a roof panel (2a) movable between a closed position and an opened position by a motor (9), the drive circuit (12) comprising an H-bridge (13) comprising switch elements (S1-S4) for controlling the speed of the motor (9); a reverse polarity protection switch (14), such as a MOSFET; and at least one measurement circuit (26, 26'). Wherein the drive circuit (12) is configured for receiving a PWM-signal with a duty cycle for operating the H-bridge (13). And wherein the at least one measurement circuit (26, 26') is configured for performing a current measurement of at least one of the switch elements (S1-S4, 14) respectively.

## Description

The present invention relates to a drive circuit for an electric motor, in particular a drive circuit for an electric motor for use in a roof assembly. The invention further relates to a current measurement circuit for a roof assembly to facilitate anti-trap detection, and a method for operating such a drive circuit.

### BACKGROUND

Roof assemblies for vehicles may be equipped with a movable panel that may be moved between an open position and a closed position. In the closed position the movable panel covers a roof opening of the roof assembly and in the open position the panel clears the roof opening and exposes an interior of the vehicle to the exterior. In order to prevent subjects and/or objects being trapped between the panel and an edge of the roof opening while the movable panel is closing, that is when the panel is moving into the closed position, the roof assembly may be provided with sensors or other means for detecting whether something is in the pathway of the movable panel. When such a situation is detected, the drive circuit operating the motor for moving the movable panel may activate the motor to stop and/or reverse movement of the panel. Such an arrangement is commonly referred to as an anti-pinch or anti-trap system ATS. As the response time for detection and activation are leading for the level of security of such an ATS, there is a need for enhancing the manner of detection.

### SUMMARY OF INVENTION

It is an object of the invention to provide additional input for an anti-trap detection system ATS.

According to the invention, this object is achieved by providing a drive circuit according to claim 1. And a method for operating a drive circuit according to claim 5.

In one aspect, the invention relates to a drive circuit for a roof assembly, the roof assembly comprising a roof panel movable between a closed position and an opened position by a motor, the drive circuit comprising an H-bridge comprising switch elements for controlling the speed of the motor. The drive circuit further comprising a reverse polarity protection switch, such as a MOSFET; and at least one measurement circuit. Wherein the drive circuit is configured for receiving a PWM-signal with a duty cycle for operating the H-bridge. And wherein the at least one measurement circuit is configured for performing a current measurement of at least one of the switch elements respectively.

The drive circuit as disclosed may provide an additional signal that may be used as input for an anti-trap algorithm, making it more robust. An anti-trap, or anti-pinch, algorithm aims to detect whether an object runs a risk of being clamped by a closing roof panel, e.g. a human finger. Hence, the additional input may be used as an additional alert and/or as an awareness signal indicating a likelihood of an object becoming trapped.

The drive circuit as disclosed may also provide an additional signal that may be used as input for a thermo-algorithm, making it more robust. A thermo-algorithm is commonly used to detect overheating of a MOSFET and in particular of components of an H-bridge. The signal may also provide an indication of self-heating of a MOSFET. For example when compared with ambient temperature within a housing of a MOSFET. It should be noted that the internal resistance of a MOSFET is dependent on temperature.

Monitoring the current flowing through a component, such as a MOSFET, over time may also provide an indication of proper functioning thereof. For example, when the current deviates significantly from expected values, this may provide an indication of a faulty MOSFET. Such detection allows for higher diagnostic coverage of the hardware. Which may help in addressing the need for higher ASIL levels, that is Automotive Safety Integrity Levels.

As may be understood, the above benefits are achieved via less components in comparison to prior art solutions, enhancing the cost efficiency of the drive circuit as disclosed over such prior art solutions.

Particular embodiments of the invention are set forth in the dependent claims.

Further objects, aspects, effects and details of particular embodiments of the invention are described in the following detailed description of a number of exemplary embodiments, with reference to the drawings.

### BRIEF DESCRIPTION OF DRAWINGS

By way of example only, the embodiments of the present disclosure will be described with reference to the accompanying drawings, wherein:
FIG. 1A illustrates a perspective view of an example of a vehicle roof with an open roof assembly;
FIG. 1B illustrates an exploded view of the open roof assembly of Fig. 1A;
FIG. 2 illustrates a prior art example of a drive circuit for operating the roof assembly of Fig. 1A;
FIG. 3 illustrates schematically an example of a drive circuit for operating the roof assembly of Fig. 1A in accordance with the invention;
FIG. 4 illustrates schematically another example of a drive circuit for operating the roof assembly of Fig. 1A in accordance with the invention;
FIG. 5 illustrates schematically an example of a measurement circuit for a drive circuit in accordance with the invention;
FIG. 6 illustrates schematically another example of a measurement circuit for a drive circuit in accordance with the invention;
FIG. 7A illustrates schematically an example of a method for operating a drive circuit in accordance with the invention;
FIG. 7B illustrates schematically another example of a method for operating a drive circuit in accordance with the invention; and
FIG. 8 is a graph illustrating an example of a PWM-signal and of a blanking signal.

### DETAILED DESCRIPTION

In the following description spatial references as, for example, front, side and rear, or underneath, below and above, or forward and rearward direction and driving movement, are made with regard to the general orientation of a vehicle, such as a passenger car. And in particular to a driver behind a steering wheel of such as vehicle. In addition, X-, Y- and Z-direction will refer to a direction corresponding to length, width and height of a vehicle. In the figures, a forward driving movement of a vehicle may e.g. be indicated by an arow D, pointing in a direction towards a front side of vehicle.

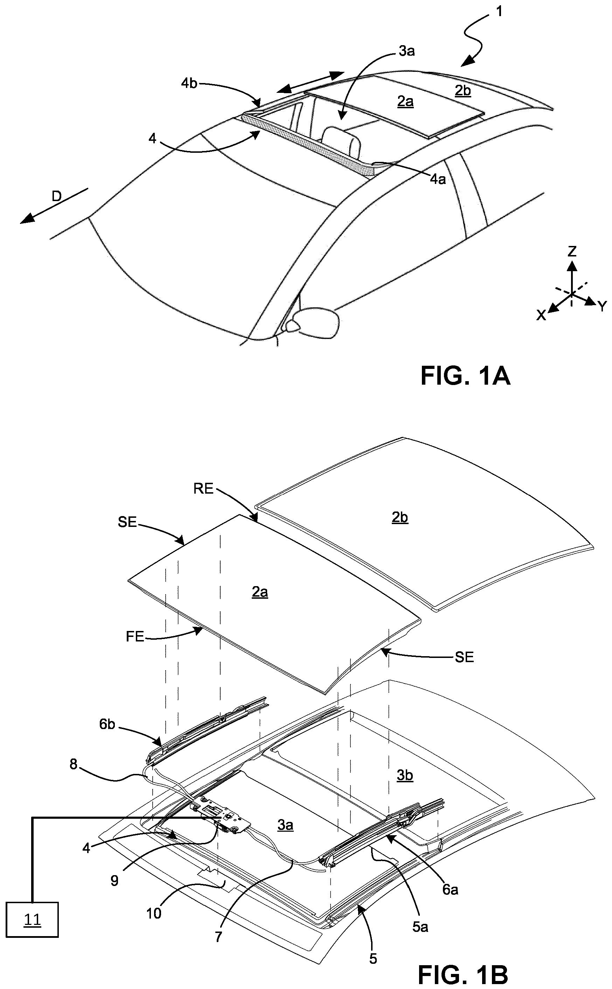

Figs. 1A and 1B illustrate a vehicle roof having an open roof assembly 1 arranged therein. The open roof assembly 1 comprises a moveable panel 2a and a fixed panel 2b. The moveable panel 2a is also referred to as a closure member, since the moveable panel 2a is moveable over a first roof opening 3a such to enable to open and to close the first roof opening 3a. A wind deflector 4 is arranged at a front side of the first roof opening 3a.

In the illustrated embodiment, the moveable panel 2a may be in a closed position, which is a position wherein the moveable panel 2a is arranged over and closes the first roof opening 3a and thus usually is arranged in a plane of the vehicle roof 1. Further, the moveable panel 2a may be in a tilted position, which is a position wherein a rear end RE of the moveable panel 2a is raised as compared to the closed position, while a front end FE of the moveable panel 2a is still in the closed position. Further, the moveable panel 2a may be in an open position, which is a position wherein the moveable panel 2a is slid open and the first roof opening 3a is partly or completely exposed. In the open position, for example both the rear end RE and front end FE may be raised as compared to the closed position.

It is noted that the illustrated vehicle roof 1 corresponds to a passenger car. The present invention is however not limited to passenger cars. Any other kind of vehicles that may be provided with a moveable panel are contemplated as well.

Fig. 1B illustrates the same vehicle roof as shown in Fig. 1A having panels 2a and 2b. In particular, while Fig. 1A shows the open roof assembly 1 in the open position, Fig. 1B is an exploded view of the open roof assembly 1 in a closed position. Further, in this exploded view of Fig. 1B, it is shown that there is a second roof opening 3b. The first and second roof openings 3a, 3b are provided in a frame 5 of the open roof assembly 1. An edge 5a of the frame 5 defines the first roof opening 3a.

The second roof opening 3b is arranged under the fixed panel 2b such that light may enter a vehicle interior space through the fixed panel 2b, presuming that the fixed panel 2b is a glass panel or a similarly transparent panel, for example made of a plastic material or any other suitable material. The second roof opening 3b with a transparent or translucent fixed panel 2b is optional and may be omitted in another embodiment of the open roof assembly 1.

The wind deflector 4 is commonly a flexible material, e.g. a woven or non-woven cloth having through holes arranged therein or a web or net. The flexible material is supported by a support structure 4a, e.g. a bar-like or tube-like structure, which structure is hingedly coupled, directly or indirectly, to the frame 5 at a hinge 4b.

The wind deflector 4 is arranged in front of the first roof opening 3a and adapts air flow when the moveable panel 2a is in the open position. In its raised position, the wind deflector 4 reduces inconvenient noise due to air flow during driving. When the moveable panel 2a is in the closed position or in the tilted position, the wind deflector 4 is held down below the front end FE of the moveable panel 2a.

Usually, the wind deflector 4 is raised by a spring force when the moveable panel 2a slides to the open position and the wind deflector 4 is pushed down by the moveable panel 2a when the moveable panel 2a slides back into its closed position. In Fig. 1A, the moveable panel 2a is shown in an open position and the wind deflector 4 is shown in a raised position. In Fig. 1B, the moveable panel 2a is shown in a closed position and the wind deflector 4 is correspondingly shown in a position in which it is held down.

Fig. 1B further illustrates a drive assembly having a first guide assembly 6a, a second guide assembly 6b, a first drive cable 7 and a second drive cable 8, and a drive motor 9. The first and second guide assemblies 6a, 6b are arranged on respective side ends SE of the moveable panel 2a and may each comprise a guide and a mechanism. The guide is coupled to the frame 5, while the mechanism comprises moveable parts and is slidably moveable in the guide. The first and the second drive cables 7, 8 are provided between the mechanisms of the respective guide assemblies 6a, 6b and the drive motor 9.

The drive cables 7, 8 couple the drive motor 9 to the mechanisms of the respective guide assemblies 6a, 6b such that upon operating the drive motor 9, the mechanisms start to move. In particular, a core of the drive cable 7, 8 is moved by the drive motor 9 such to push or pull on the mechanisms of the respective guides 6a, 6b. Such a drive assembly is well known in the art and is therefore not further elucidated herein. Still, any other suitable drive assembly may be employed as well without departing from the scope of the present invention.

In the illustrated embodiment, the guide assemblies 6a, 6b may start movement with raising the rear end RE of the moveable panel 2a, thereby bringing the moveable panel 2a in the tilted position. Then, from the tilted position, the guide assemblies 6a, 6b may start to slide to bring the moveable panel 2a in the open position. The present invention is however not limited to such embodiment. For example, in another embodiment, the moveable panel 2a may be moveable to a tilted position by raising the rear end RE, while an open position is reached by first lowering the rear end RE and then sliding the moveable panel 2a under the fixed panel 2b or any other structure or element provided behind the rear end RE of the moveable panel 2a. In further exemplary embodiments, the moveable panel 2a may be merely moveable between a closed position and a tilted position or between a closed position and an open position.

In the illustrated embodiment, the drive motor 9 is mounted at a recess 10 near or below the front end FE of the moveable panel 2a in the closed position. In another embodiment, the drive motor 9 may be positioned at any other suitable position or location. For example, the drive motor 9 may be arranged near or below the rear end RE of the moveable panel 2a in the closed position or below the fixed panel 2b.

A control unit 11 is schematically illustrated and is operatively coupled to the drive motor 9. The control unit 11 may be any kind of processing unit, either a software controlled processing unit or a dedicated processing unit, like an ASIC, as well known to those skilled in the art. The control unit 11 may be a stand-alone control unit or it may be operatively connected to an-other control unit, like a multipurpose, generic vehicle control unit. In yet another embodiment, the control unit 11 may be embedded in or be part of such a generic vehicle control unit. Essentially, the control unit 11 may be embodied by any control unit suitable for, capable of and configured for performing operation of the drive motor 9 and thus the moveable roof assembly 1. An anti-trap system may be implemented by the control unit 11, for example by executing an algorithm to that purpose.

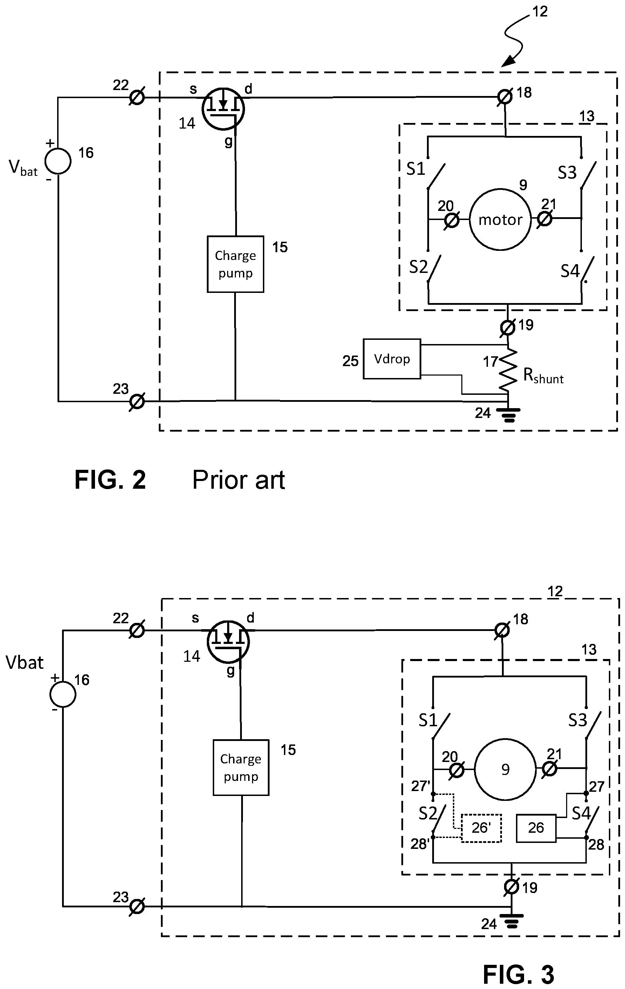

Referring to Fig. 2, a prior art example of a drive circuit 12 is illustrated schematically. The drive circuit 12 includes a H-bridge 13 consisting of four switches S1-S4 for operating a motor, such as the drive motor 9 of the example of Fig. 1B. The H-bridge has a pair of input terminals 18, 19 and a pair of output terminals 20, 21. The output terminals 20, 21 are connected to the motor 9. The drive circuit 12 further includes a switch 14 for reverse polarity protection. In this example a MOSFET, such as a PMOS, NMOS or IGBT MOSFET. The drive circuit further includes, at least in case of a MOSFET as reverse polarity protection, a charge pump 15 to ensure that the switch 14 for reverse polarity protection may be put in conducting mode during operation of the drive circuit 12. The drive circuit 12 is powered by a DC voltage battery or other suitable power source 16, which power source is connected to a pair of input terminals 22, 23, one positive and one negative, of the drive circuit 12. The reverse polarity protection MOSFET 14 is connected in series with its source and drain between the positive input terminal 22 of the drive circuit 12 and the positive input terminal 18 of the H-bridge 13. Operation of the reverse polarity protection MOSFET 14 is controlled via the charge pump 15 which is in a circuit branch that is connected between a gate of the MOSFET 14 and the negative input terminals 23. The voltage provided by the charge pump determines whether and how the MOSFET is conducting or not. Should the terminals of a power supply be connected in a wrong manner, i.e. ground and positive switched, then the reverse polarity MOSFET prevents short-circuiting the H-bridge.

For driving the motor a Pulse Width Modulation PWM - signal is used to operate the switches S1-S4. This allows for a soft start and/or soft stop by means of a duty cycle of the PWM-signal. The duty cycle determines the duration of the opening and closing of the switches, thereby controlling the voltage that is supplied to the motor and therewith a speed of the motor may be controlled. For driving the motor in a first rotational direction, the switches S1 and S4 are opened and closed simultaneously and repetitively. While for driving the motor in a second rotational direction, opposite to the first, the switches S3 and S2 are opened and closed simultaneously and repetitively. Hence, the duty cycle of the PWM-signal will determine the speed at which the motor will rotate, while the choice of switch pair will determine the direction of the motor. Depending on the manner in which the motor is connected, the first direction may be either forward / closing, or reverse / opening.

In order to detect pinching of objects, changes in the current drawn by the motor may be monitored. Thereto a Shunt resistor 17 is placed between a common negative side of the H-bridge 13, in this example as available on the input terminal 19 of the H-bridge, and the ground line 24. Which ground line 24 is also connected to the negative terminal 23 of the drive circuit 12. A voltage over the Shunt resistor 17 may be monitored for a drop therein as being indicative of a change in the current drawn by the motor 9. Thereto a measurement circuit 25 is connected in parallel to the Shunt resistor 17. The thus measured voltage signal is indicative of the current drawn by the motor and can be used for pinch detection.

Referring to Fig. 3, a first example of a drive circuit according to the invention is illustrated schematically. Herein for the same components and elements as in Fig. 2, the same reference numbers are used. In this example, no Shunt resistor is present and the common negative side of the H-bridge 13, as available on the input terminal 19, is directly in contact with the ground line 24.

In this example, in order to acquire the voltage signal that may be used for pinch detection, a measurement circuit 26 is configured to measure the voltage over the MOSFET switch S4. The measurement circuit has input terminals 27, 28 that are to be connected at different sides of the switch S4. To ensure that the voltage is measured when the MOSFET is conducting, the measurement signal needs to be sampled in synchronization with the PWM-signal operating the switch S4. As this switch is only operated, and thus conducting, when the motor is rotating in the first direction, a second measurement circuit 26' may be configured to measure the voltage over the MOSFET switch S2, which is conducting when the motor is operated to rotate in the second direction. This allows for bi-directional monitoring of the voltage for pinch detection.

For each MOSFET the resistance between drain and source when conducting, i.e. Rdsₒₙ will be known in advance. And in case of a pinch, as the inventor has discovered, an increase in current leads to a higher voltage drop across the internal resistance of the MOSFET. Accordingly, a microcontroller, such as e.g. part of the control unit 11 in Fig. 1B, may calculate the current drawn based on the measured voltage signal and the known Rdsₒₙ. This may then be used as input for a pinch detection system.

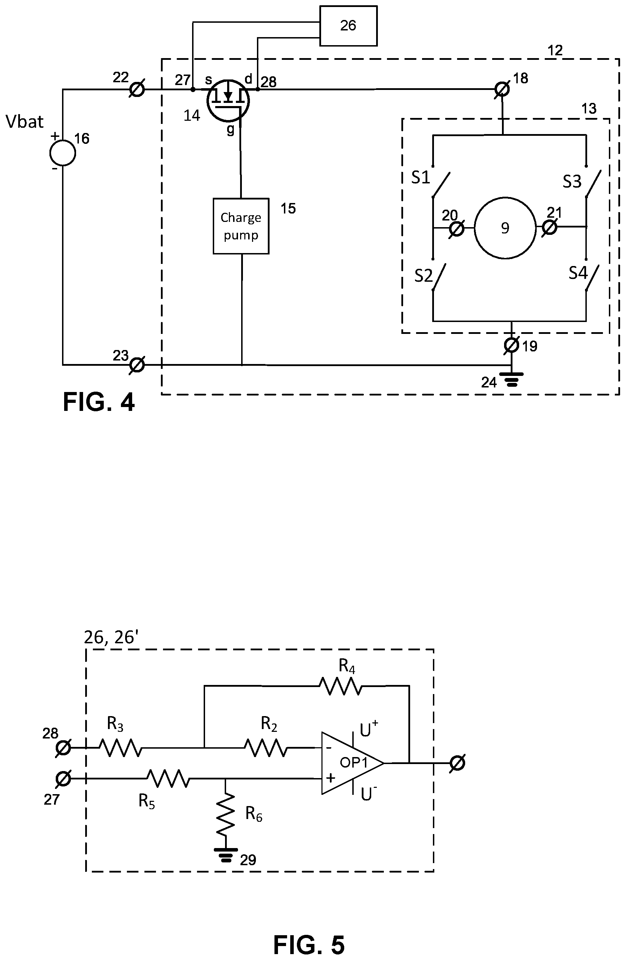

Referring to Fig. 4, another example of a drive circuit according to the invention is illustrated schematically. Herein for the same components and elements as in Fig. 3, the same reference numbers are used. In this example, again no Shunt resistor is present and the common negative side of the H-bridge 13, as available on the input terminal 19, is directly in contact with the ground line 24.

In this example, in order to acquire the voltage signal that may be used for pinch detection, the measurement circuit 26 is configured to measure the voltage over the reverse polarity protection MOSFET 14. One terminal 27 is connected at a node located at or near the source side of the MOSFET, while the other terminal 28 is connected at a node located at or near the drain side of the MOSFET.

The inventor has discovered that changes in the current drawn by the motor may also be reflected in the voltage over the reverse polarity MOSFET. As in case of a pinch, an increase in current leads to a higher voltage drop across the internal resistance of the reverse polarity MOSFET. Hence, monitoring this voltage signal may be indicative of the current drawn by the motor.

When the current measurement is performed over the MOSFETs of the H-bridge, the properties of the PWM-signal for the drive circuit may influence the measurement. In particular, the duty cycle of the PWM-signal will determine the time window wherein a measurement may be performed. For example, with a carrier frequency of 20kHz. and a 20% duty cycle, the time window is in the order of 0.02 ms. When initiating, from the start the current will be rising and needs to level out during the remainder of the conducting phase. Accordingly, at a low duty cycle an aliasing effect may occur and the measurement may be prone to deviations. This effect does not occur, or is of less of influence, when performing measurements over the reverse polarity MOSFET, as this is not operated by the PWM-signal.

The examples of drive circuits as disclosed thus provide an output signal via its respective measurement circuit, which additional signal may be used as input for an anti-trap algorithm, making it more robust. Such anti-trap algorithm may be executed by a control unit as e.g. control unit 11. The additional signal may also be used as further input for a thermo-algorithm, making it more robust. A thermo-algorithm is commonly used to detect overheating of components, such as a MOSFET and in particular of components of an H-bridge. For example, as two MOSFETs are commonly provided in single package, and each connected in a different branch of an H-bridge, a temperature sensor placed in between in the same package may provide an indication of (over)heating. The current signal may help, in case of a rise in temperature detected, to identify which of the two MOSFETs is heating up. The signal may also provide an indication of self-heating of a MOSFET. For example when compared with ambient temperature of the component within the package. It should be noted that the internal resistance of a MOSFET is dependent on temperature, so a current-temperature profile may be known. And deviations may be detected.

Fig. 5 illustrates an example of the measurement circuit 26, 26'. The measurement circuit 26, 26' providing an amplifying stage. The terminal 28 connected to the node at the drain side of the MOSFET is connected over a transfer resistor network R2, R3, R4 to the negative input of an operational amplifier OP1. The terminal 27 connected to the node at the source side of the MOSFET is connected over a voltage dividing resistor network R5, R6 to the positive input of the operational amplifier OP1 and ground line 29. The amplifier outputs the voltage signal, with reference to ground 29, that is indicative of the motor current. This signal may also be referred to as a current sense signal. This voltage signal or current sense signal may also be used to determine whether the MOSFET is conducting or not.

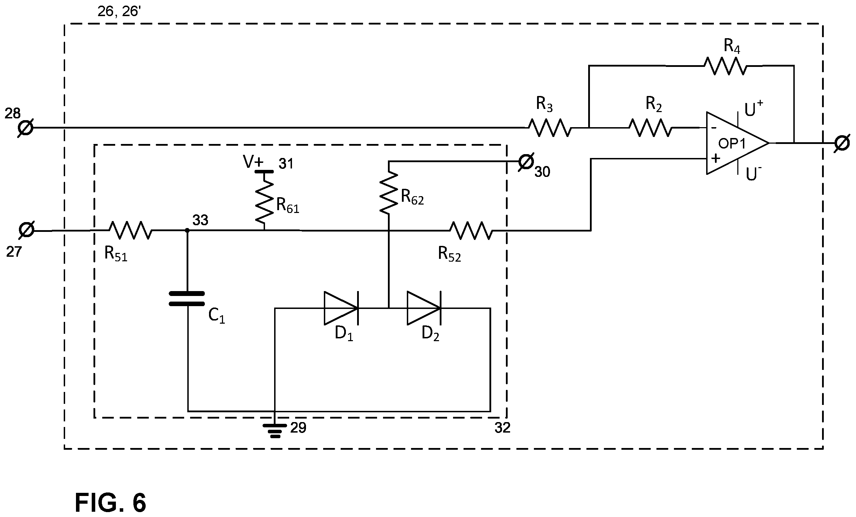

Fig. 6 illustrates another example of the measurement circuit 26, 26'. In this example, the measurement circuit 26, 26' is expanded with a filter stage portion 32 preceding the amplifying stage and is connected to the terminal 27. More in particular, the voltage divider resistor network of Fig. 5 is replaced with the filter stage portion 32. The filter stage 32 includes an RC-filter consisting of a resistor R51 and a filter capacitor C1. An output of the RC-network R51, C1 is available at a node 33. The filter stage further includes two diodes that are connected in parallel between the node 33 and ground 29 in opposite conducting direction. A positive voltage source 31, in this example in the order of +5 V, is connected over a resistor R61 to the node 33. And a terminal 30 for receiving a blanking signal is connected over another resistor R62 to the node 33. The node 33 is further connected over a resistor R52 to the positive input terminal of the operational amplifier OP1.

The terminal 30 for receiving the blanking signal allows to improve measurement as it will cause the capacitor C1 to be cleared, that is no charge will be stored after the blanking signal is provided. This blanking signal will be provided via a micro controller i.e. control unit, such as e.g. the control unit 11 of Fig. 1B, and will be synchronized in counter phase with the PWM-signal. Preferably, the microcontroller activates the blanking signal for a period that lasts just beyond the start of a conducting phase of the MOSFET over which the measurement is performed. This ensures that a measurement is performed when the MOSFET is fully conducting and not when just starting up or initiating the conducting phase.

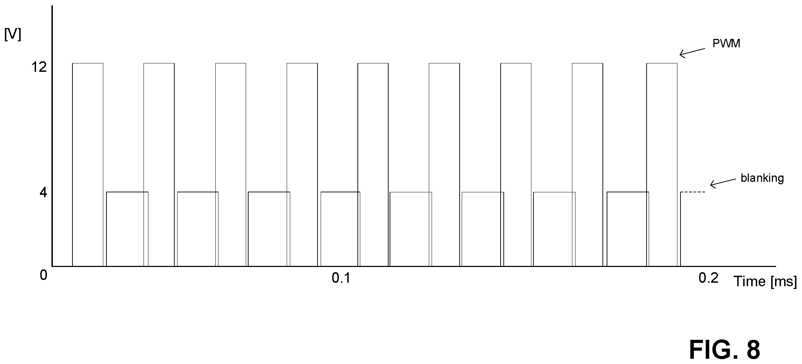

When measurement is performed over MOSFETS of the H-bridge, as in Fig. 4, the blanking signal provides an improvement by eliminating ripples or interference from a, partially, charged capacitor C1. Furthermore, when the blanking signal is set up to partly overlap the active part of the duty cycle of the PWM-signal, influence off potential aliasing effects may also be reduced, as maintaining the capacitor of the RC-filter stage initially clear will cause a current measurement to start at an appropriate point in time. That is when the MOSFET is in full conduction mode. Referring to Fig. 8, a graph is shown illustrating an example of a PWM-signal and of such a partly overlapping blanking signal. In this example, the duty cycle is set to 40%. The blanking signal is in counterphase therewith and overlaps the PWM signal until the rising flank has reached its full amplitude.

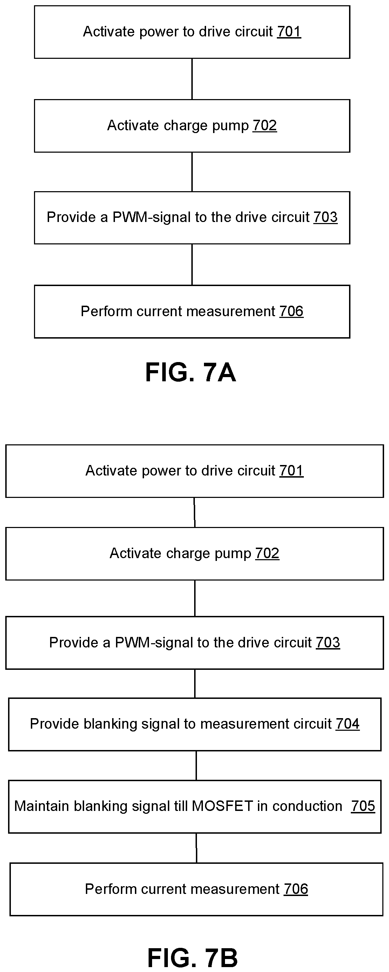

Referring to Fig. 7A, an example of a method for operating the drive circuit of Fig. 3 and/or Fig. 4 is illustrated. The method may be executed by a micro controller, such as control unit 11 of Fig. 1B. With a drive circuit provided 12, the method begins with activating 701 the power source 16 for the drive circuit 12. This is followed by activating 702 the charge pump 15 for controlling conduction of the reverse polarity protection switch 14. When the motor is started for operating a roof panel, the method continues with providing a PWM-signal 703 with a predetermined duty cycle to the H-bridge of the drive circuit for controlling the speed of the motor. The speed of the motor is directly related to the chosen predetermined duty cycle. During the operating of the roof panel, current measurement is performed 706 on one or more switch elements S1-S4, 14 respectively.

Referring to Fig. 7B, another example of a method for operating the drive circuit of Fig. 3 and/or Fig. 4 is illustrated. Similar operations as in the example of Fig. 7A have the same reference number. In addition to Fig. 7A, a blanking-signal is provided 704 to the measurement circuit 26, 26', which blanking-signal is in counter phase with the PWM-signal. The blanking signal is maintained 705 until the switch element of which the current is to be measured is in conduction. Thereto, the blanking-signal is to partially overlap with an initial portion of the active duty cycle of PWM-signal, to ensure that the MOSFET has initiated properly and is in, or at least near, full conduction phase. In this manner, influence of the filter stage of the measurement circuit on the signal to be measured may be prevented.

Detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in expectedly any appropriately detailed structure. In particular, features presented and described in separate de-pendent claims may be applied in combination and any advantageous combination of such claims are herewith disclosed.

Further, it is contemplated that structural elements may be generated by application of three-dimensional (3D) printing techniques. Therefore, any reference to a structural element is in-tended to encompass any computer executable instructions that in-struct a computer to generate such a structural element by three-dimensional printing techniques or similar computer-controlled manufacturing techniques. Furthermore, any such reference to a structural element is also intended to encompass a computer readable medium carrying such computer executable instructions.

Further, the terms and phrases used herein are not intended to be limiting, but rather to provide an understandable description of the invention. The terms "a" or "an", as used herein, are defined as one or more than one. The term plurality, as used here-in, is defined as two or more than two. The term another, as used herein, is defined as at least a second or more. The terms including and/or having, as used herein, are defined as comprising (i.e., open language). The term coupled, as used herein, is de-fined as connected, although not necessarily directly.

Although the present invention has been described above with reference to specific embodiments, it is not intended to be limited to the specific form set forth herein. Rather, the invention is limited only by the accompanying claims and other embodiments than the specific above are equally possible within the scope of these appended claims.

Furthermore, although exemplary embodiments have been described above in some exemplary combination of components and/or functions, it should be appreciated that, alternative embodiments may be provided by different combinations of members and/or functions without departing from the scope of the present disclosure. In addition, it is specifically contemplated that a particular feature described, either individually or as part of an embodiment, can be combined with other individually described features, or parts of other embodiments.

## Claims

1. A drive circuit (12) for a roof assembly, the roof assembly comprising a roof panel (2a) movable between a closed position and an opened position by a motor (9), the drive circuit (12) comprising:
an H-bridge (13) comprising switch elements (S1-S4) for controlling the speed of the motor (9);
a reverse polarity protection switch (14), such as a MOSFET; and
at least one measurement circuit (26, 26');
wherein the drive circuit (12) is configured for receiving a PWM-signal with a duty cycle for operating the H-bridge (13);
wherein the at least one measurement circuit (26, 26') is configured for performing a current measurement of at least one of the switch elements (S1-S4, 14) respectively.

2. Drive circuit according to claim 1, wherein the measurement circuit (26, 26') is arranged for delivering a voltage indicative of a current signal as input for an anti-trap algorithm.

3. Drive circuit according to claim 1 or 2, wherein the measurement circuit (26, 26') comprises a filter stage (32) having a filter capacitance (C1); and
wherein the measurement circuit (26, 26') is configured for receiving a blanking signal for clearing the filter capacitance (C1).

4. Drive circuit according to any of claims 1 - 3, further comprising:
a charge pump (15) configured for controlling conduction of the reverse polarity protection switch (14).

5. A method for operating a drive circuit (12) according to any of the preceding claims the method comprising:
activating (701) a power source (16) for the drive circuit (12);
providing a PWM-signal (703) with a predetermined duty cycle to the H-bridge (13);
performing a current measurement (706) of on one or more switch elements (S1-S4, 14) respectively.

6. A method according to claim 5, for operating a drive circuit (12) according to claim 4, the method further comprising:
activating (702) the charge pump (15) to bring the reverse polarity protection switch (14) in conduction.

7. Method according to claim 5 or 6, further comprising:
providing (704) a blanking signal to the measurement circuit (26, 26');
wherein the blanking signal is in counter phase with the PWM-signal.

8. Method according to claim 7, further comprising:
maintaining (705) the blanking signal until the switch element (S1-S4, 14) of which the current is to be measured is in conduction.

9. A control unit for a roof assembly for a vehicle, configured for executing the method according to any of the preceding claims 5 - 8.

10. A roof assembly for a vehicle, comprising:
a roof panel (2a) movable between a closed position and an opened position by a motor (9);
and a control unit according to claim 9.

11. A vehicle, comprising:
a roof assembly according to claim 10.
